# EUROPEAN PATENT APPLICATION

(11) **EP 0 654 827 A1**
(43) Date of publication of application: **24.05.1995**
(21) Application number: 94108048.3
(22) Date of filing: 25.05.1994
(51) Int. Cl.: H01L 27/085, H01L 29/78, H01L 29/808

(54) **Integrated power cascode**

(30) Priority: 26.05.1993 US 67770
(71) Applicant: TEXAS INSTRUMENTS INCORPORATED, Dallas Texas 75265 (US)
(72) Inventor: Malhi, Satwinder, Garland, TX 75044 (US)
(74) Representative: Schwepfinger, Karl-Heinz, Dipl.-Ing.

(57) **Abstract**

A power cascode including a low voltage MOSFET connected to a high voltage JFET is disclosed. This structure and device provides superior input capacitance and comparable on-resistance as compared to a power MOSFET.

## Description

### BACKGROUND OF THE INVENTION

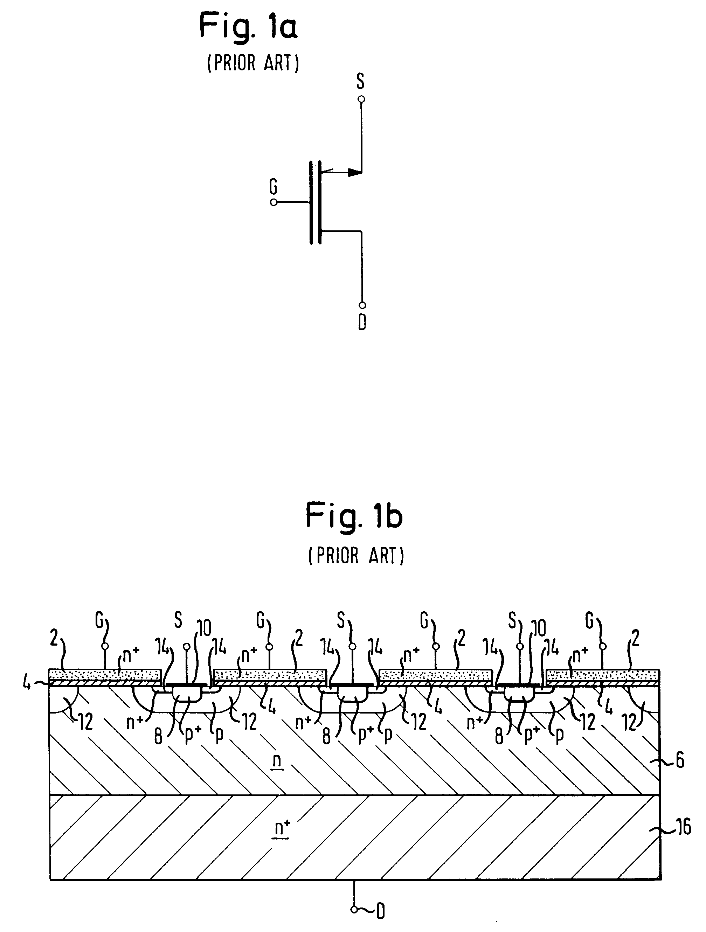

For power supply and many other applications, a high voltage (greater than 200 volts) power device which has MOSFET (metal oxide semiconductor field effect transistor) input control is desirable. Figure 1a illustrates a schematic drawing of a conventional vertical power MOSFET and figure 1b illustrates a cross-sectional/schematic drawing of a plurality of the devices of the type shown in figure 1a as fabricated with a semiconductor. With reference to these figures, the gate, source and drain electrodes are designated G, S, and D respectively. Gate 2 which can comprise a highly doped semiconductor is fabricated over insulator 4 which can comprise oxide. This highly doped semiconductor is shown as n+. The + designation indicates a higher donor dopant concentration than n-type bulk semiconductor region 6. Source electrode S makes contact to highly doped p+ semiconductor region 8 through contact 10 which can comprise titanium silicide. The p+ designation indicates a higher acceptor dopant concentration than p-type well region 12. N+ region 14 serves as the source and contacts source electrode S through contact 10. Drain electrode D makes contact to n+ semiconductor region 16 which serves as the drain of the MOSFET.

In operation, assuming an enhancement mode device, a positive voltage placed on gate electrode G, causes a depletion region (not shown) in p-type well region 12. In connection with a differential voltage being placed on the source electrode S and drain electrode D, according to the voltage at the gate electrode G, the depletion region increases to a point where strong inversion of the energy bands occur and a channel (not shown) will form which allows current to flow between the drain electrode D and the source electrode S.

The power MOSFET as illustrated in figures 1a and 1b, is widely used for the applications previously discussed. However, the input capacitance per unit area, given the power constraints, particularly at second breakdown voltages of greater than 200 volts is large. and thus prevents MOSFET operation at several megahertz.

### BRIEF DESCRIPTION OF THE DRAWINGS

Figure 1a illustrates a schematic drawing of a conventional power MOSFET.

Figure 1b illustrates a cross-sectional/schematic drawing of a plurality of MOSFETS of the type shown in figure 1a as fabricated with a semiconductor.

Figure 2a illustrates a schematic drawing of an integrated power cascode according to the invention.

Figure 2b illustrates a cross-sectional/schematic drawing of a plurality of MOSFETS of the type shown in figure 2a as fabricated with a semiconductor.

Drawing reference numerals and characters will be carried forward.

### DETAILED DESCRIPTION OF THE INVENTION

The invention provides a power device and structure which can provide a lower input capacitance per unit area (as compared to a conventional power MOSFET) with a resistance from drain to source R_{ds} per unit area being comparable to that of a conventional power MOSFET. As such, this power device and structure is operable at much higher frequencies as compared with a conventional power MOSFET. The power device according to the invention shall be referred to as a power cascode and it comprises a vertical junction field effect transistor (vertical JFET, also called VFET) connected to a lateral MOSFET.

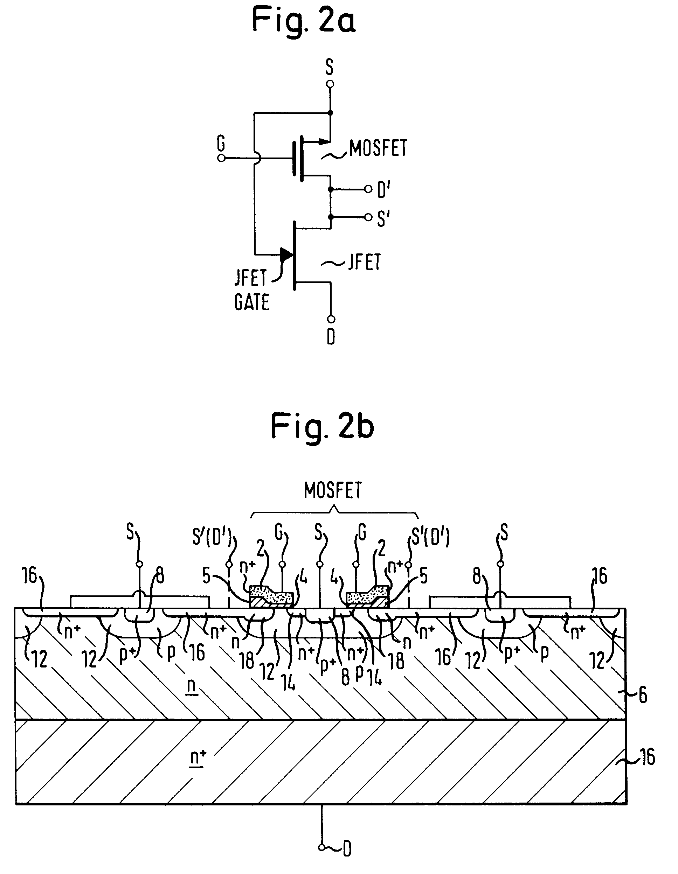

Figure 2a illustrates a schematic drawing of an integrated power cascode according to the invention and figure 2b illustrates a cross-sectional/schematic drawing of a plurality of MOSFETS of the type shown in figure 2a as fabricated with a semiconductor. The JFET includes two n+ regions 16 connected together by strap 18. Each n+ region 16 serves as a drain/source for the JFET and MOSFET of the power cascade and as such is indicated by S' (JFET source) and alternatively, D' (MOSFET drain). Although illustrated as separate electrodes in order to indicate functionality in figure 2a, D' and S' are the same electrode. The MOSFET of the power cascode comprises n-type region 18 which lies adjacent gate 2 with an insulator interposed therebetween. This insulator which can comprise oxide, includes a gate insulator 4 and isolation insulator 5. Note that the gate is formed in a step-like fashion because the underlying insulator is of a different thickness, with insulator 4 being necessarily thinner than isolation insulator 5. Additionally, note that although region 16 was designated the drain of the power MOSFET in figure 1b, region 16 in figure 2b serves as the drain of the JFET. The connection to the power cascode from the outside environment is therefore the same as to a conventional vertical power MOSFET.

In operation, a channel (not shown) is formed under strong inversion within p-type well region 12 in connection with a positive voltage on gate G. Current then flows between source electrode S and electrode S'(D') through n-type region 18 and n+ region 14 in the MOSFET in connection with a differential voltage placed on these electrodes. Current flows between the drain electrode D and electrode S'(D') in the JFET in connection with the voltage placed on the JFET gate which is connected to the source of the MOSFET. During operation, the vertical JFET sustains most of the voltage across the device a substantial portion of which occurs in n-type bulk region 6. By optimized layout parameters, the lateral MOSFET will have only 10 volts to 30 volts across it and the rest of high voltage will appear across the JFET. As such, the lateral MOSFET can be characterized as a low voltage MOSFET and the vertical JFET can be characterized as a high voltage JFET. Since much less surface area can be devoted to the MOS gate 2 as compared with a comparable conventional vertical power MOSFET, the input capacitance is smaller that of a comparable conventional power MOSFET. Note that the depth and thickness of the n-type bulk region 6, which functions as a drift region between a electromagnetic field created between the differentially voltaged electrodes S'(D') and D, can be the same in a comparable vertical power MOSFET and the invention's lateral MOSFET. Consequently, the on-resistances within these two devices can be substantially the same. Therefore, the invention's power cascode can be fabricated without much deviation from the fabrication steps used to form a conventional vertical power MOSFET.

The lateral MOSFET according to the invention can be fabricated in silicon and the vertical JFET can be fabricated in GaAs, preferably with the JFET being packaged on a silicon substrate. In this manner, a hybrid GaAs VFET/silicon MOSFET (hybrid GaAs vertical JFET/silicon MOSFET) power switch can be made. This embodiment of the invention is particularly useful in providing highly efficient, low voltage power supplies. This embodiment allows extremely fast operation due to the lower resistivity associated with GaAs as compared with silicon, in the vertical JFET. Additionally the use of the GaAs permits the silicon die area to be dramatically reduced (in comparison with that using a silicon vertical JFET.

The power cascode of the invention can be fabricated as a discrete device or alternatively and preferably, as an integrated structure on a semiconductor wafer according to well semiconductor fabrication methods.

Although the invention has been described in detail herein with reference to its preferred embodiments and certain described alternatives, it is to be understood that this description is by way of example only, and it is not to be construed in a limiting sense. It is to be further understood that numerous changes in the details of the embodiments of the invention, and that additional embodiments of the invention will be apparent to, and may be made by persons of ordinary skill in the art having reference to this description. For instance, although an n-type MOSFET was discussed a p-type MOSFET can be used with an appropriate change in the dopant types used in the JFET of the power cascode. Accordingly, p-type regions can be substituted for n-type regions and vice-versa with appropriate voltages applied. Device element functions, e.g. drain and source, must be interchanged accordingly. It is contemplated that all such changes and additional embodiments are within the spirit and true scope of the invention as claimed below.

## Claims

1. An integrated power device comprising:
a semiconductive substrate having a first conductivity type;
a first doped region having a second conductivity type opposite said first conductivity type formed at a surface of said substrate;
a second doped region having said second conductivity type formed in said first doped region, said second doped region having a higher dopant concentration that said first doped region;
a third doped region having said first conductivity type formed adjacent to and surrounding said second doped region;
a fourth doped region having said first conductivity type, said fourth doped region being formed in said first doped region and extending beyond said first doped region, said fourth doped region being separated from said third doped region by a channel region;
a gate formed above said channel region but insulated therefrom;
a fifth doped region formed in said substrate having said second conductivity type, said fifth doped region being in contact with said fourth doped region and separated from said first doped region; and
a source terminal in conductive contact with said second doped region and said fifth doped region;
a drain contact conductively connected to said substrate, having said first conductivity type and being separated from said first and fifth doped regions.

2. An integrated power device as in claim 1, wherein said first conductivity type is N and said second conductivity type is P.

3. An integrated power device as in claim 1 or claim 2, further comprising a layer of silicon dioxide separating said channel region from said gate.

4. An integrated power device as in claim 1, claim 2 or claim 3, wherein the top portion of said substrate comprises silicon and the bottom portion comprises gallium arsenide.

5. An integrated power device as in any preceding claim, wherein said fourth doped region is formed in an annular pattern surrounding said first doped region.

6. An integrated power device as in claim 5, wherein said fifth doped region is formed in an annular pattern surrounding said fourth doped region.

7. An integrated power device as in any preceding claim further comprising a sixth doped region formed adjacent to said fifth doped but but separated from said fourth doped region, said fourth doped region being conductively connected to said fourth doped region.

8. An integrated power device as in claim 7, wherein said sixth doped region is formed in an annular pattern surrounding said fifth doped region.

9. A method for forming an integrated power device comprising:
providing a semiconductive substrate having a first conductivity type;
forming a first doped region having a second conductivity type opposite said first conductivity type formed at a surface of said substrate;
forming a second doped region having said second conductivity type formed in said first doped region, said second doped region having a higher dopant concentration that said first doped region;
forming a third doped region having said first conductivity type formed adjacent to and surrounding said second doped region;
forming a fourth doped region having said first conductivity type, said fourth doped region being formed in said first doped region and extending beyond said first doped region, said fourth doped region being separated from said third doped region by a channel region;
forming a gate formed above said channel region but insulated therefrom;
forming a fifth doped region formed in said substrate having said second conductivity type, said fifth doped region being in contact with said fourth doped region and separated from said first doped region;
and
forming a source terminal in conductive contact with said second doped region and said fifth doped region;
forming a drain contact conductively connected to said substrate, having said first conductivity type and being separated from said first and fifth doped regions.

10. A method for forming an integrated power device as in claim 9, wherein said first conductivity type is N and said conductivity type is P.

11. A method for forming an integrated power device as in claim 9 or claim 10, further comprising the step of forming a layer of silicon dioxide separating said channel region from said gate.

12. A method for forming an integrated power device as in claim 9, claim 10 or claim 11, wherein the top portion of said substrate comprises silicon and the bottom portion comprises gallium arsenide.

13. A method for forming an integrated power device as in any of claims 9 to 12, wherein said fourth doped region is formed in an annular pattern surrounding said first doped region.

14. A method for forming an integrated power device as in claim 13, wherein said fifth doped region is formed in an annular pattern surrounding said fourth doped region.

15. A method for forming an integrated power device as in any of claims 9 to 14, further comprising a sixth doped reegion formed adjacent to said fifth doped region but separated from said fourth doped region, said fourth doped region being conductively connected to said fourth doped region.

16. A method for forming an integrated power device as in claim 15, wherein said sixth doped region is formed in an annular pattern surrounding said fifth doped region.
